Europäisches Patentamt

**European Patent Office**

**Office européen des brevets**

(11) Veröffentlichungsnummer: **0 568 771 A1**

(12) **EUROPÄISCHE PATENTANMELDUNG**

(21) Anmeldenummer: **93101793.3**

(22) Anmeldetag: **05.02.93**

(51) Int. Cl.5: **G01K 3/14**, G01K 11/12

(30) Priorität: **25.04.92 DE 4213717**

(43) Veröffentlichungstag der Anmeldung:
**10.11.93 Patentblatt 93/45**

(84) Benannte Vertragsstaaten:
**BE CH DE ES FR GB IT LI**

(71) Anmelder: **ASEA BROWN BOVERI AG**
**Haselstrasse**
**CH-5401 Baden(CH)**

(72) Erfinder: **Ricka, Jaroslav**

Länggassestrasse 20
**CH-3012 Bern(CH)**
Erfinder: **Wüthrich, Max**
**Lindenfeldweg 9**
**CH-3400 Burgdorf(CH)**

(74) Vertreter: **Hetzer, Hans Jürgen et al**
**ABB Management AG**
**TEI-Immaterialgüterrecht**
**Wiesenstrasse 26**
**CH-5401 Baden (CH)**

(54) Verfahren zur Ermittlung eines Häufigkeits-Zeitprofils von Ereignissen sowie Vorrichtung zur Durchführung des Verfahrens.

㊼ Bei einem Verfahren zur Ermittlungen eines Häufigkeits-Zeitprofils von Ereignis-Folgen und der entsprechenden Vorrichtung wird nach der Synchronisation eines externen Startsignals ein Messfenster geöffnet. Solange das Messfenster offen ist werden die Clockperioden gezählt. Tritt ein Ereignis auf, wird es mit der bis zu seinem Auftreten abgelaufenen Anzahl Clockperioden, der sogenannten Zeitmarke, markiert. Die bis dahin ermittelte Anzahl Ereignisse mit dieser spezifischen Zeitmarke wird um eins erhöht. Durch wiederholtes Öffnen des Messfensters entsteht ein Häufigkeits-Zeitprofil der Ereignis-Folgen dadurch, dass für jeden Wert der Zeitmarke die Anzahl der entsprechend markierten Ereignisse zusammengezählt wird.

Die Ereignis-Erfassung, die Ereignis-Analyse und die Ereignis-Endverarbeitung erfolgen alle für jedes einzelne Ereignis in Echtzeit in einem einzigen Messschritt, d.h. die Verarbeitung einer Ereignisfolge ist unmittelbar nach dem Ablauf eines Messzyklus bereits abgeschlossen. Die Anzahl verarbeitbarer Ereignisse pro Messzyklus, bzw. die zeitliche Auflösung zwischen zwei aufeinander folgenden Ereignissen ist ausschliesslich durch die zeitliche Dauer zwischen Erfassung und Endverarbeitung der Einzelereignisse beschränkt.

*FIG. 1*

EP 0 568 771 A1

## Technisches Gebiet

Die Erfindung betrifft ein Verfahren zur Ermittlungen eines Häufigkeits-Zeitprofils von Ereignissen sowie eine Vorrichtung zur Durchführung des Verfahrens.

Insbesondere kommt das Verfahren und die entsprechende Vorrichtung bei der Auswertung des Messignals eines verteilten optischen Temperatursensors zum Einsatz.

Eine Vorrichtung zu Durchführung des Verfahrens gemäss dem Oberbegriff des Anpruchs 1 wird von der Firma LeCroy unter der Bezeichnung "1879 PIPELINE MULTIHIT TIME-TO-DIGITAL CONVERTER" vertrieben (siehe LeCroy Corporation, Research System Division: "1992 Research Instrumentation Catolog", Seite 51-53).

## Stand der Technik

Bei verteilten optischen Temperatursensoren wird ein kurzer Laserpuls in eine Multimode-Faser injiziert. Aus der Intensität des zurückgestreuten Raman-Lichts, in Abhängigkeit von der Zeit nach dem Laserpuls, kann auf die örtliche Temperaturverteilung in der Faser geschlossen werden. Weil das Raman-Licht sehr schwach ist, muss über viele solche Einzelmessungen (Messzyklen) gemittelt werden.

Für die zeitabhängige Detektion des Raman-Lichtes eignet sich neben analogen Verfahren auch das sogenannte Photonen-Zählen. Bei diesem Verfahren wird üblicherweise die Ankunftszeit eines einzigen rückgestreuten Photons in einem vorgewählten Zeitfenster (Messfenster) ermittelt. Mit einem solchen Einphoton-Verfahren wird eine sehr gute zeitliche Auflösung erreicht (und damit auch eine gute Ortsauflösung in der Temperaturmessung). Weil aber in einem Messzyklus nur ein Photon aus der rückgestreuten Lichtmenge ausgenützt wird, und weil die Verarbeitung des Ereignisses noch eine gewisse Zeit nach Ablauf des Zeitfensters beansprucht, ist die für eine gute Mittelung des Signals notwendige Messzeit sehr lang. Eine Verkürzung der Messzeit kann dadurch erreicht werden, dass innerhalb eines Zeitfensters nicht nur ein einziges, sondern möglichst viele Photonen-Ereignisse verarbeitet werden.

Diese Anforderung erfüllt beispielsweise der erwähnte Multihit Time-To-Digital Converter, welcher von der Firma LeCroy vertrieben wird. Mit Ereignis oder Hit wird im folgenden die ansteigende oder abfallende Flanke eines digitalen Signals verstanden. Photonen können in einer speziellen Detektionsschaltung in solche Signale umgewandelt werden.

Zentrales Element des erwähnten 1879 PIPELINE MULTIHIT TIME-TO-DIGITAL CONVERTERS ist ein schnelles Schieberegister. Während eines Messzyklus wird das Schieberegister so gefüllt, dass sein Inhalt, eine Reihe von digitalen "1" und "0", dem zeitlichen Auftreten der zu messenden Ereignisse entspricht. Im Schieberegister wird das Zeitintervall, gemessen vom Start des Messzyklus bis zum Auftreten eines Ereignisses, in eine binäre Zahl gewandelt. Ein Stop-Signal beendet den Messzyklus. Anschliessend kann während einer Messpause entschieden werden, ob ein Ereignis berücksichtigt werden soll oder nicht. Nach dieser Messpause werden die Ereignisse zeitlich codiert und in einen Speicher gelesen, von wo sie anschliessend zur Endverarbeitung ausgelesen werden können.

Beim erwähnten Messgerät erfolgen also Ereignis-Erfassung, Ereignis-Analyse und Ereignis-Endverarbeitung hintereinander. Zuerst werden alle Ereignisse erfasst. Erst anschliessend werden alle Ereignisse analysiert und zur Endverarbeitung bereitgestellt. Die Messzeit ist lang und beträgt bei diesem Gerät 412µs + ca. 50ns pro Ereignis. Ein neuer Messzyklus kann erst nach Ablauf der Messpause gestartet werden. Die Endverarbeitung, d.h. die Ermittlung des Häufigkeits-Zeitprofils erfolgt nicht während der Messung, sondern erst danach.

## Darstellung der Erfindung

Aufgabe der vorliegenden Erfindung ist es, ein Verfahren zur Ermittlungen eines Häufigkeits-Zeitprofils von Ereignis-Folgen in einem Messfenster (Zeitfenster) sowie eine Vorrichtung zur Durchführung des Verfahrens anzugeben,

a) das mehrere Ereignisse während eines Messzyklus verarbeiten kann,

b) bei dem die Verarbeitungszeit aber möglichst klein, und insbesondere möglichst nicht die Dauer des Messfensters überschreiten soll, sodass das Häufigkeits-Zeitprofil in Echtzeit, ohne verarbeitungsbedingte Messpausen, ermittelt werden kann.

Diese Aufgabe wird beim erfindungsgemässen Verfahren zur Ermittlungen eines Häufigkeits-Zeitprofils von Ereignissen, bei dem

a) das zeitliche Auftreten von mehreren verschiedenen Ereignissen innerhalb eines Messfensters erfasst, und

b) die Häufigkeit des zeitlichen Auftretens der Ereignisse während einer bestimmten Anzahl von Messzyklen ermittelt wird,

dadurch gelöst, dass

c) sowohl die Ereignis-Erfassung als auch die Ereignis-Analyse und die Ereignis-Endverarbeitung in Echtzeit erfolgen, wobei

d) die Anzahl verarbeitbarer Ereignisse pro Messzyklus nur durch die zeitliche Dauer zwischen Erfassung und Endverarbeitung der Einzelereignisse beschränkt ist;

e) nach der Synchronisation eines externen Startpulses mit dem System-Takt

f) ein Messfenster geöffnet wird, und

g) die Anzahl der seit der Oeffnung des Messfensters verstrichenen Taktperioden gezählt wird;

h) ein auftretendes Ereignis mit dem System-Takt synchronisiert wird und

i) mit der Anzahl seit der Oeffnung des Messfensters verstrichenen Taktperioden, der sogenannten Zeitmarke, markiert wird; und

k) die bis dahin ermittelte Anzahl Ereignisse mit dieser spezifischen Zeitmarke um eins erhöht wird, wobei

l) durch wiederholtes Öffnen des Messfensters ein Häufigkeits-Zeitprofil der Ereignis-Folgen dadurch entsteht, dass für jeden Wert der Zeitmarke die Anzahl der entsprechend markierten Ereignisse zusammengezählt wird.

Ein Vorteil des erfindungsgemässen Verfahrens besteht darin, dass sowohl Ereignis-Erfassung wie Ereignis-Analyse und Ereignis-Endverarbeitung in Echtzeit, das heisst während der Messung erfolgen und nicht, wie beim erwähnten Gerät der Firma LeCroy, nach der Messung. Dadurch fallen die durch Verarbeitung bedingte Messpausen weg und die Gesamt-Messzeit wird erheblich verkürzt.

Weiter wird eine Vorrichtung zur Durchführung des oben genannten Verfahrens angegeben, wobei die Vorrichtung gekennzeichnet ist durch

a) eine Steuereinheit, welche vorzugsweise einen Personal-Computer (PC) umfasst, zur Steuerung des Verfahrens,

b) einen Mehrfach-Zeitintervall-Analysator (MTIA) zur Erfassung, Analyse und Verarbeitung der Ereignis-Folgen und

c) ein PC-Interface, zwischen dem MTIA und dem PC, welches einerseits die Anpassung der vom PC kommenden Signale auf die vom MTIA geforderte Form vornimmt und andererseits die vom MTIA kommenden Signale auf die vom PC geforderte Form anpasst, wobei der MTIA umfasst:

d) zwei Eingänge, von denen der eine ein Ereignis-Eingang und der andere ein Startpuls-Eingang ist;

e) einen Clock-Generator, welcher einen digitalen System-Takt generiert;

f) eine Startpuls-Synchronisation, deren erster Eingang mit dem Startpuls-Eingang verbunden ist, und deren zweiter Eingang mit dem Ausgang des Clock-Generators verbunden ist, und welche den am Startpuls-Eingang anliegenden Startpuls mit der System-Clock synchronisiert;

g) eine Start-Stop-Logik, deren erster Eingang mit dem Ausgang der Startpuls-Synchronisation verbunden ist, und deren zweiter Eingang mit der System-Clock verbunden ist, und welche das Oeffnen und Schliessen des Messfensters steuert;

h) einen Zeitmarken-Zähler, dessen erster Eingang mit der System-Clock verbunden ist, und dessen zweiter Eingang mit dem Ausgang der Start-Stop-Logik verbunden ist, und welcher solange die Pulse der System-Clock zählt, wie der Ausgang der Start-Stop-Logik aktiv ist;

i) eine Ereignis-Synchronisation, deren erster Eingang mit dem Ereignis-Eingang verbunden ist, und deren zweiter Eingang mit dem Ausgang des Clock-Generators verbunden ist, und welche das am Ereignis-Eingang anliegende Ereignissignal mit der System-Clock synchronisiert;

k) ein AND-Gatter, dessen erster Eingang mit dem Ausgang der Ereignis-Synchronisation verbunden ist, und dessen zweiter Eingang mit dem Ausgang der Start-Stop-Logik verbunden ist, und welches die beiden Eingänge logisch UND verknüpft;

l) ein Zeitmarken-Register, dessen Load-Eingang mit dem Ausgang des AND-Gatters verbunden ist, und dessen Daten-Eingang mit dem Ausgang des Zeitmarken-Zählers verbunden ist, und welches auf eine aktive Flanke des an seinem Load-Eingang liegenden Signals den am Ausgang des Zeitmarken-Zählers anliegenden Wert einliest;

m) einen Histogramm-Speicher, dessen Adress-Eingang mit dem Ausgang des Zeitmarken-Registers verbunden ist, und welches den Inhalt der durch den Adress-Eingang adressierten Speicherstelle an seinen Daten-Ausgang gibt;

n) einen Plus-Eins-Zähler, dessen Daten-Eingang mit dem Daten-Ausgang des Histogramm-Speichers verbunden ist, und welcher den an seinem Daten-Eingang liegenden Wert um eins erhöht und diesen Wert über seinen Daten-Ausgang an die durch den Adress-Ausgang des Zeitmarken-Registers adressierte Speicherstelle des Histogramm-Speichers schreibt;

o) eine Ereignis-Steuerungslogik, welche die Steuerung der Schritte d-n vornimmt;

p) eine Steuerungslogik, welche den Daten- und Adressenfluss von und zum PC-Interface steuert.

Bei der erfindungsgemässen Vorrichtung wird die einem Ereignis zugeordnete Speicherstelle während der Messung inkrementiert. Die Histogramm-Bildung (Endverarbeitung) findet also während der Messung statt.

Kern der Erfindung ist es also, ein Verfahren zur Ermittlungen eines Häufigkeits-Zeitprofils von Ereignissen sowie eine entsprechende Vorrichtung anzugeben, bei welchem Verfahren sowohl die Ereignis-Erfassung wie die Ereignis-Analyse und die Ereignis-Endverarbeitung während der Messung in Echtzeit erfolgen.

Die erfindungsgemässe Anordnung zeichnet sich besonders dadurch aus, dass die gesamte Verarbeitung einer Folge von mehreren Ereignissen, einschliesslich der Abspeicherung, in Echtzeit geschieht und die Dauer des Messfensters nicht übersteigt. Damit wird die Gesamt-Messzeit drastisch verringert.

Selbstverständlich ist die Anwendung des erfindungsgemässen Verfahrens und der entsprechenden Vorrichtung nicht auf verteilte Temperatursensoren beschränkt, sondern kann überall dort angewendet werden, wo Häufigkeits-Zeitprofile von Ereignissen gemessen werden müssen.

Aus der Gesamtheit der abhängigen Ansprüche ergeben sich weitere vorteilhafte Ausführungsformen.

## Kurze Beschreibung der Zeichnungen

Nachfolgend wir die Erfindung anhand von Ausführungsbeispielen im Zusammenhang mit den Zeichnungen näher erläutert.

Es zeigen:

**Fig. 1** ein Blockschaltbild einer erfindungsgemässen Vorrichtung

**Fig. 2** ein Timing-Diagramm des erfindungsgemässen Verfahrens

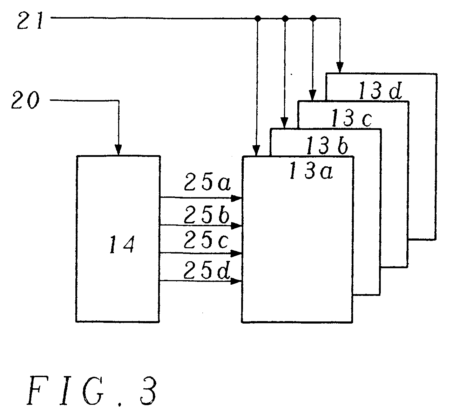

**Fig. 3** eine Anwendung der erfindungsgemässen Vorrichtung zur Erhöhung der Zeitauflösung

Die in den Zeichnungen verwendeten Bezugszeichen und deren Bedeutung sind in der Bezeichnungsliste zusammengefasst aufgelistet. Grundsätzlich sind in den Figuren gleiche Teile mit gleichen Bezugszeichen versehen.

## Wege zur Ausführung der Erfindung

Beim erfindungsgemässen Verfahren wird nach der Synchronisation eines externen Startsignals ein Messfenster geöffnet. Solange das Messfenster offen ist werden die Taktperioden gezählt. Tritt ein Ereignis auf, wird es mit der bis zu seinem Auftreten abgelaufenen Anzahl Taktperioden, der sogenannten Zeitmarke, markiert. Die bis dahin ermittelte Anzahl Ereignisse mit dieser spezifischen Zeitmarke wird um eins erhöht. Durch wiederholtes Öffnen des Messfensters entsteht ein Häufigkeits-Zeitprofil der Ereignis-Folgen dadurch, dass für jeden Wert der Zeitmarke die Anzahl der entsprechend markierten Ereignisse zusammengezählt wird.

Sowohl die Ereignis-Erfassung, als auch die Ereignis-Analyse und die Ereignis-Endverarbeitung erfolgen für jedes einzelne Ereignis in einem einzigen Schritt und nicht erst nachdem die Erfassung aller Ereignisse abgeschlossen ist. Mit anderen Worten, die drei Schritte werden in Echtzeit ausgeführt.

Die Anzahl verarbeitbarer Ereignisse pro Messzyklus, bzw. die zeitliche Auflösung zwischen zwei aufeinander folgenden Ereignissen, die sogenannte Pulspaarauflösung, ist ausschliesslich durch die zeitliche Dauer zwischen Erfassung und Endverarbeitung eines Einzelereignisses beschränkt.

In einer bevorzugten Ausführungsform des erfindungsgemässen Verfahrens besteht die Möglichkeit das Messfenster erst nach Ablauf einer bestimmten Verzögerungszeit zu öffnen. Dadurch können z.B. allfällige Einschwingzeiten einer Detektionseinheit, welche im Normalfall nicht Null sind, kompensiert werden.

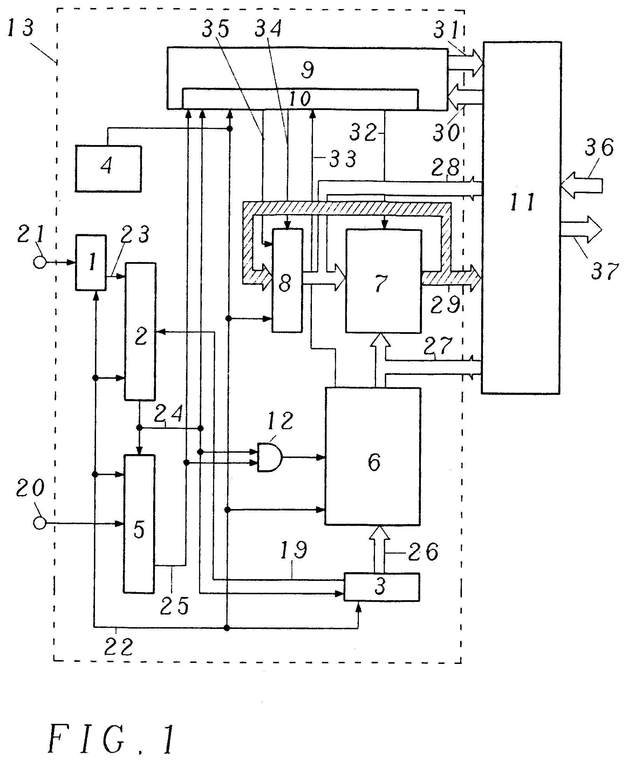

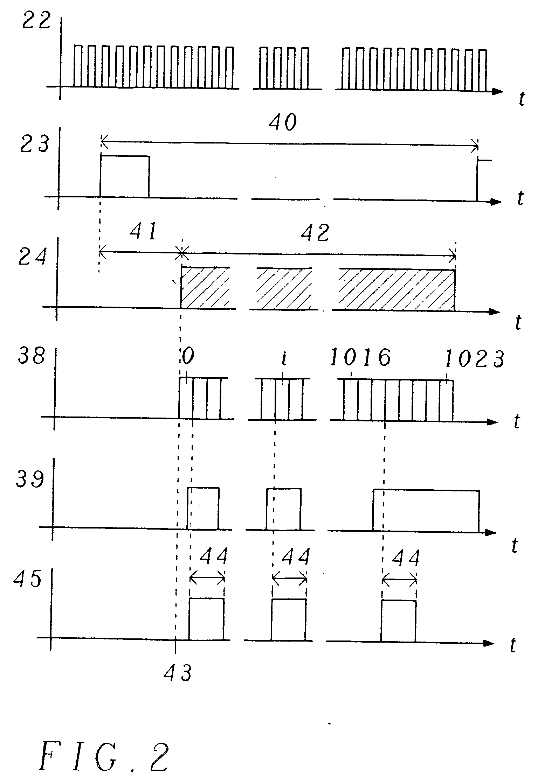

Anhand der Figuren 1 und 2 soll nun der Zusammenhang zwischen dem eben erläuterten, erfindungsgemässen Verfahren und der erfindungsgemässen Vorrichtung erklärt werden.

Die erfindungsgemässe Vorrichtung umfasst eine Steuereinheit, vorzugsweise ein Personal-Computer (PC), der über eine PC-Interface (11) mit einem Mehrfach-Zeitintervall-Analysator (13) verbunden ist. Der Mehrfach-Zeitintervall-Analysator (13) wird im folgenden als Multi-Time-Intervall-Analyzer, kurz MTIA, bezeichnet. Mit Grossbuchstaben werden im folgenden Signale bezeichnet, während normal geschriebene Bezeichnungen für die entsprechenden Funktionsblöcke stehen.

Der MTIA (13) weist zwei Eingänge auf, einen Startpuls-Eingang (21) und einen Ereignis-Eingang (20). Beide sind je mit einer Synchronisations-Schaltung (1,5) verbunden. Der Startpuls-Eingang (21) mit der Startpuls-Synchronisation (1), der Ereignis-Eingang (20) mit der Ereignis-Synchronisation (5). In diesen beiden Synchronisations-Schaltungen (1,5) werden die asynchron auftretenden Signale STARTPULS und EREIGNIS mit der System-Clock (22) synchronisiert. Die System-Clock (22) wird im Clock-Generator (4) erzeugt und gibt den Takt für den MTIA (13) vor. Alle Steuerungs- und Timing-Aufgaben werden durch die Ereignis-Steuerung (10) in für den Fachmann üblicher Weise gesteuert und bedürfen keiner weiteren Erläuterung. Dasselbe gilt für die Kommunikation zwischen dem PC-Interface (11) und dem MTIA (13), welche durch die Steuerungslogik (9) in fachüblicher Weise gesteuert wird.

Wird nun an den Eingang (21) der Startpuls-Synchronisation (1) ein Startpuls gegeben, so bewirkt die Start-Stop-Logik (2), dass das Messfenster, dargestellt durch das entsprechende Steuersignal (MESSFENSTER, 24), nach einer allfälligen Verzögerung geöffnet wird. MESSFENSTER (24) ist auch mit dem Zeitmarken-Zähler (3) verbunden. Dieser beginnt die Anzahl Clockperioden zu zählen, so lange wie MESSFENSTER (24) aktiv ist. Tritt nun am Ereignis-Eingang (20) ein Ereignis auf, so wird das Signal mit der System-Clock(22) synchronisiert (25) und im AND-Gatter (12) mit dem MESSFENSTER (24) logisch UND verknüpft. Der Ausgang des AND-Gatters (12) ist also nur so lange "1", wie sowohl MESSFENSTER (24) als auch EREIGNIS (25) "1" sind. Dieses UND-verknüpfte Signal kann als Ladebefehl für das Zeitmarken-Register (6) verwendet werden. Das Zeitmarken-Register (6) liest den aktuellen Zeitmarken-Zählerwert ein, sobald an seinem Ladeeingang eine "1" auftritt.

Der Ausgang des Zeitmarken-Register (6) ist mit dem Adress-Eingang des Histogramm-Speichers (7) verbunden und adressiert somit die Speicherstelle, welche dem Zeitmarken-Register-Inhalt, d.h. der Anzahl abgelaufener Clock-Perioden entspricht. Der Wert, der an dieser Speicherstelle gespeichert ist, wird nun ausgelesen und dem Plus-Eins-Zähler (8) weitergegeben. Dieser addiert zu den an seinem Eingang liegenden Wert eins und gibt diesen um eins inkrementierten Wert an den Daten-Eingang des Histogramm-Speichers (7) weiter. Dieser neue Wert wird wieder an dieselbe Stelle zurückgeschrieben, da die Adresse ja immer noch im Zeitmarken-Register (6) vorhanden ist. Während des ganzen oben erläuterten Prozesses werden allfällige weitere Ereignisse ignoriert, da sonst die Adresse des Histogramm-Speichers (7) verändert wurde. Die Ereignis-Steuerung (10) sorgt für diese temporäre Sperre.

Solange das Messfenster offen ist werden jene Speicherstellen um eins inkrementiert, welche durch die ereignisspezifische Anzahl Clockperioden adressiert wurden. Durch wiederholtes Oeffnen und Schliessen des Messfensters erhält man also ein Häufigkeits-Zeitprofil.

Der MTIA (13) steht über ein PC-Interface (11) mit dem PC in Verbindung. Vom PC aus kann das System programmiert und gesteuert werden. Das PC-Interface (11) wandelt dabei die vom PC kommenden Daten in Daten, Adressen und Befehle für den MTIA (13) um. In gleichem Masse werden auch die Signale vom MTIA (13) im PC-Interface (11) in eine für den PC lesbare Form gebracht. Die Kommunikation mit dem PC-Interface (11) erfolgt vom MTIA (13) aus über die Steuerbusse STEUERUNG IN (30) und STEUERUNG OUT (31) sowie die Datenbusse DATEN IN (28) und DATEN OUT (29) und den Adressbus (27). Die beiden Steuerbusse (30, 31) sind mit der Steuerungslogik (9) verbunden. Der Datenbus DATEN IN (28) steht mit dem Ausgang des Plus-Eins-Zählers (8) und dem Daten-Eingang des Histogramm-Speichers (7) in Verbindung. Der Daten-Ausgang des Histogramm-Speichers (7) ist über den Datenbus DATEN OUT (29) mit dem PC-Interface (11) verbunden. Der Adressbus (27) verbindet den Ausgang des Zeitmarken-Registers (6) und den Adress-Eingang des Histogramm-Speichers (7) mit dem PC-Interface.

Figur 2 zeigt den zeitlichen Ablauf des erfindungsgemässen Verfahrens bzw. das Timing-Diagramm der erfindungsgemässen Vorrichtung.

Nach einer allfälligen, bestimmten Verzögerungszeit (41) wird auf ein Startpuls (23) das Messfenster (24) geöffnet. Diese Zeit gilt als Zeitreferenz (43). Gleichzeitig beginnt der Zeitmarken-Zähler (3) mit dem Zählen der Zeitmarken (38). Die Zeitmarken laufen von 0 bis 1023. Tritt beispielsweise während der 1. Clockperiode ein Ereignis (39) auf, wird dieses synchronisiert (d.h. erfasst) und mit der Nummer "1" markiert (d.h. analysiert). Dieses synchronisierte und markierte Ereignis wird nun während der Verarbeitungszeit (44) wie erläutert endverarbeitet. Während dieser Zeit (44) werden vorübergehend keine anderen Ereignisse akzeptiert. Die genau gleichen Schritte laufen bei den Ereignissen mit der Zeitmarke "i" bzw. "1019" ab. Am Ende der 1023-sten Zeitmarke (38) wird das Messfenster (24) geschlossen. Zwischen dem Öffnen und dem Schliessen des Messfensters ist die Zeitdauer (42) verstrichen. Direkt nach dem Schliessen des Messfensters (24) kann durch einen erneuten Startpuls (23) das Fenster wieder geöffnet werden. Durch dieses wiederholte Oeffnen und Schliessen des Messfensters (24) mit der Periode (40) erhält man schliesslich das gewünscht Häufigkeits-Zeitprofil.

In einer ersten bevorzugten Ausführungsform der erfindungsgemässen Vorrichtung umfasst der Zeitmarken-Zähler (3) einen (K + 1)-Bit Binärzähler. Nach dem Öffnen des Messfensters zählt er von 0 bis $2^K$-1. Das (K + 1)te Bit (19) ist mit der Start-Stop-Logik (2) verbunden und dient als Steuerbit dazu, das Messfenster am Ende der letzten, d.h. ($2^K$-1)-ten Clockperiode zu schliessen. Das Zeitmarken-Register (6) umfasst dementsprechend ein K-Bit Register. Der Histogramm-Speicher (7) umfasst entsprechend ein ($2^K$ x D) RAM und der Plus-Eins-Zähler (8) ein parallel ladbarer binärer D-Bit Zähler, wobei D die Wortbreite der Daten bedeutet.

In einer zweiten bevorzugten Ausführungsform der erfindungsgemässen Vorrichtung ist das Zeitmarken-Register (6) in mehrfacher Ausführung vorhanden. Dadurch können, während das letzte Ereignis verarbeitet wird, schon wieder neue Ereignisse erfasst werden. Besteht das Mehrfach-Zeitmarken-Register aus R einzelnen KBit-Registern, so können, während der Ereignisverarbeitung, Ereignissequenzen bestehend aus maximal R neuen Ereignissen erfasst werden.

Die zeitliche Auflösung von zwei Ereignissen, welche nur durch die Verarbeitungszeit eines Ereignisses limitiert ist, kann durch diese spezielle Ausführung des Zeitmarken-Registers (6) gesenkt werden.

In einer dritten bevorzugten Ausführungsform der erfindungsgemässen Vorrichtung werden mehrere MTIAs (13a-d) parallel eingesetzt. Sie werden mit zeitversetzten System-Clocks getaktet. Eine vorgeschaltete Ereignis-Verteilungseinheit (14) übernimmt die Verteilung der Ereignisse (25a-d) auf die MTIAs (13a-d). Mit einer solchen Anordnung kann die zeitliche Auflösung des gesamten Systems erhöht werden. Eine Parallelschaltung von 4 MTIAs entspricht beispielsweise einer Viertelung des System-Clocks und damit einer viermal höheren Zeitauflösung.

Anhand eines Zahlenbeispiels sollen die Vorteile des erfindungsgemässen Verfahren und der entsprechenden Vorrichtung aufgezeigt werden.

Die Ereignis-Verarbeitung, d.h. die Adressierung des Speichers, das Auslesen, Inkrementieren und das erneute Beschreiben des Speichers dauert bei einer implementierten Version maximal 44ns. Die Pulspaar-Auflösung beträgt damit auch 44ns. Wird das System mit einer 250MHz Clock getaktet, ergibt sich eine zeitliche Auflösung von 4ns. Bei einem 10-Bit Zeitmarken-Register ist das Messfenster also $(2^{10}) \times 4ns = 4\mu s$ offen. Während der totalen Verarbeitungszeit von $4\mu s$ können also 90 Ereignisse erfasst, analysiert und verarbeitet werden. Erweitert man das System um die als bevorzugte Ausführungsformen erläuterten Varianten, werden sowohl die Verarbeitungszeit von 44ns, als auch die Zeitauflösung von 4ns vermindert und damit auch die Anzahl verarbeitbarer Ereignisse vergrössert. Zusätzliche Erweiterungen werden durch Erhöhung der Anzahl Kanäle K bzw. der Datenbreite D erreicht.

Insgesamt weist das erfindungsgemässe Verfahren und die entsprechende Vorrichtung also eine wesentlich verkürzte Verarbeitungszeit auf. Das System ist leicht zu erweitern. Gleichzeitig können die Zeitauflösung und die Pulspaar-Auflösung verbessert werden, während die Verarbeitungszeit vermindert wird.

**Bezeichnungsliste**

| | |
|---|---|
| 1 | Startpuls-Synchronisation |
| 2 | Start-Stop-Logik |
| 3 | Zeitmarken-Zähler |
| 4 | Clock-Generator |
| 5 | Ereignis-Synchronisation |
| 6 | Zeitmarken-Register |
| 7 | Histogramm-Speicher |
| 8 | Plus-Eins-Zähler |
| 9 | Steuerlogik |
| 10 | Ereignislogik |
| 11 | PC-Interface |
| 12 | AND-Gatter |
| 13 | Mehrfach-Zeitintervall-Analysator (MTIA) |
| 13a | Mehrfach-Zeitintervall-Analysator 1 (MTIA 1) |
| 13b | Mehrfach-Zeitintervall-Analysator 2 (MTIA 2) |
| 13c | Mehrfach-Zeitintervall-Analysator 3 (MTIA 3) |
| 13d | Mehrfach-Zeitintervall-Analysator 4 (MTIA 4) |
| 14 | Ereignis-Verteilungseinheit |
| 19 | Bit (K + 1) |
| 20 | Ereignis-Eingang |
| 21 | Startpuls-Eingang |
| 22 | Clock |
| 23 | synchronisierter Startpuls |
| 24 | Messfenster |
| 25 | synchronisiertes Ereignis |
| 25a | synchronisiertes Ereignis 1 |
| 25b | synchronisiertes Ereignis 2 |
| 25c | synchronisiertes Ereignis 3 |
| 25d | synchronisiertes Ereignis 4 |
| 26 | Zähler Ausgang |
| 27 | Adress-Bus |
| 28 | Datenbus IN |
| 29 | Datenbus OUT |
| 30 | Steuerbus IN |
| 31 | Steuerbus OUT |
| 32 | Write |
| 33 | Increment Request |
| 34 | Increment Enable |
| 35 | Load Enable |
| 36 | PC-Bus IN |
| 37 | PC-Bus OUT |
| 38 | Zeitmarken |
| 39 | unsynchronisierte Ereignisse |
| 40 | Messzyklus-Periode |
| 41 | Verzögerungszeit |
| 42 | Messfensterlänge |
| 43 | Zeitreferenz |
| 44 | Verarbeitungszeit |
| 45 | Ereignis-Verarbeitung |
| i | i-te Zeitmarke |
| 1016 | 1016-te Zeitmarke |
| 1023 | 1023-te Zeitmarke |

**Patentansprüche**

1. Verfahren zur Ermittlungen eines Häufigkeits-Zeitprofils von Ereignissen, bei dem

    a) das zeitliche Auftreten von mehreren verschiedenen Ereignissen innerhalb eines Messfensters erfasst, und

    b) die Häufigkeit des zeitlichen Auftretens der Ereignisse während einer bestimmten Anzahl von Messzyklen ermittelt wird,

dadurch gekennzeichnet, dass

c) sowohl die Ereignis-Erfassung als auch die Ereignis-Analyse und die Ereignis-Endverarbeitung in Echtzeit erfolgen, wobei

d) die Anzahl verarbeitbarer Ereignisse pro Messzyklus nur durch die zeitliche Dauer zwischen Erfassung und Endverarbeitung der Einzelereignisse beschränkt ist;

e) nach der Synchronisation eines externen Startpulses mit dem System-Takt

f) ein Messfenster geöffnet wird, und

g) die Anzahl der seit der Oeffnung des Messfensters verstrichenen Taktperioden gezählt wird;

h) ein auftretendes Ereignis mit der System-Takt synchronisiert wird und

i) mit der Anzahl seit der Oeffnung des Messfensters verstrichenen Taktperioden, der sogenannten Zeitmarke, markiert wird; und

k) die bis dahin ermittelte Anzahl Ereignisse mit dieser spezifischen Zeitmarke um eins erhöht wird, wobei

l) durch wiederholtes Öffnen des Messfensters ein Häufigkeits-Zeitprofil der Ereignis-Folgen dadurch entsteht, dass für jeden Wert der Zeitmarke die Anzahl der entsprechend markierten Ereignisse zusammengezählt wird.

2. Verfahren nach Anspruch 1, dadurch gekennzeichnet, dass das Messfenster erst nach einer bestimmten Verzögerungszeit nach dem Startpuls geöffnet wird.

3. Vorrichtung zur Durchführung des Verfahrens nach Anspruch 1, gekennzeichnet durch

a) eine Steuereinheit, welche vorzugsweise einen Personal-Computer (PC) umfasst, zur Steuerung des Verfahrens,

b) einen Mehrfach-Zeitintervall-Analysator (MTIA 13) zur Erfassung, Analyse und Verarbeitung der Ereignis-Folgen sowie

c) ein PC-Interface (11), zwischen dem MTIA (13) und dem PC, welches einerseits die Anpassung der vom PC kommenden Signale (36, 37) auf die vom MTIA (13) geforderte Form vornimmt und andererseits die vom MTIA (13) kommenden Signale (29, 31) auf die vom PC geforderte Form anpasst, wobei der MTIA (13) umfasst:

d) zwei Eingänge (20, 21), von denen der eine ein Ereignis-Eingang (20) und der andere ein Startpuls-Eingang (21) ist;

e) einen Clock-Generator (14), welcher einen digitalen System-Takt (22) generiert;

f) eine Startpuls-Synchronisation (1), deren erster Eingang mit dem Startpuls-Eingang (21) verbunden ist, und deren zweiter Eingang mit dem Ausgang des Clock-Generators (4) verbunden ist, und welche den am Startpuls-Eingang (21) anliegenden Startpuls mit der System-Clock (22) synchronisiert;

g) eine Start-Stop-Logik (2), deren erster Eingang mit dem Ausgang (23) der Startpuls-Synchronisation (1) verbunden ist, und deren zweiter Eingang mit der System-Clock (22) verbunden ist, und welche das Oeffnen und Schliessen des Messfensters steuert;

h) einen Zeitmarkenzähler (3), dessen erster Eingang mit der System-Clock (22) verbunden ist, und dessen zweiter Eingang mit dem Ausgang (24) der Start-Stop-Logik (2) verbunden ist, und welcher solange die Pulse der System-Clock zählt (22), wie der Ausgang (24) der Start-Stop-Logik (2) aktiv ist;

i) eine Ereignis-Synchronisation (5), deren erster Eingang mit dem Ereignis-Eingang (20) verbunden ist, und deren zweiter Eingang mit dem Ausgang (22) des Clock-Generators (4) verbunden ist, und welche das am Ereignis-Eingang (20) anliegende Ereignissignal mit der System-Clock (22) synchronisiert;

k) ein AND-Gatter (12), dessen erster Eingang mit dem Ausgang (25) der Ereignis-Synchronisation (5) verbunden ist, und dessen zweiter Eingang mit dem Ausgang (24) der Start-Stop-Logik verbunden ist, und welches die beiden Eingänge logisch UND verknüpft;

l) ein Zeitmarken-Register (6), dessen Load-Eingang mit dem Ausgang des AND-Gatters (12) verbunden ist, und dessen Daten-Eingang mit dem Ausgang (26) des Zeitmarken-Zählers (3) verbunden ist, und welches auf eine aktive Flanke des an seinem Load-Eingang liegenden Signals den am Ausgang (26) des Zeitmarken-Zählers anliegenden Wert einliest;

m) einen Histogramm-Speicher (7), dessen Adress-Eingang mit dem Ausgang des Zeitmarken-Registers (6) verbunden ist, und welches den Inhalt der durch den Adress-Eingang adressierten Speicherstelle an seinen Daten-Ausgang gibt;

n) einen Plus-Eins-Zähler (8), dessen Daten-Eingang mit den Daten-Ausgang des Histogramm-Speichers (7) verbunden ist, und welcher den an seinem Daten-Eingang liegenden Wert um eins erhöht und diesen Wert über seinen Daten-Ausgang an die durch den Adress-Ausgang des Zeitmarken-Registers (6) adressierte Speicherstelle des Histogramm-Speichers (7) schreibt;

o) eine Ereignis-Steuerungslogik (10), welche die Ansteuerung der Funktionsblöcke nach den Ansprüchen 3d-n vornimmt;

p) eine Steuerungslogik (9), welche den Daten- und Adressenfluss von und zum PC-Interface (11) steuert.

4. Vorrichtung nach Anspruch 3, dadurch gekennzeichnet, dass

a) der Zeitmarkenzähler (3) einen $(K+1)$-Bit Binärzähler umfasst, welcher nach dem Öffnen des Messfensters von 0 bis $2^K$-1 zählt, wobei das $(K+1)$-te Bit mit der Start-Stop-Logik (2) verbunden ist und in der Start-Stop-Logik (2) bewirkt, dass das Messfenster geschlossen wird;

b) das Zeitmarken-Register (6) ein K-Bit Register umfasst;

c) der Histogramm-Speicher (7) ein $(2^K$ x D)-Bit RAM umfasst, wobei D die Wortbreite der Daten bedeutet;

d) der Plus-Eins-Zähler (8) einen parallel ladbaren, binären D-Bit Zähler umfasst.

5. Vorrichtung nach einem der vorangegangenen Ansprüche, dadurch gekennzeichnet, dass

a) das Zeitmarken-Register (6) R einzelne K-Bit Register und eine Registerlogik umfasst, welche zwischen dem Ausgang des AND-Gatters (12) und den einzelnen Register geschaltet ist, wobei

b) die Registerlogik die einzelnen Register so ansteuert, dass während der Verarbeitung eines Ereignisses noch R-1 weitere Ereignisse erfasst werden können, womit

c) die zeitliche Auflösung zwischen zwei Ereignissen erhöht wird.

6. Vorrichtung nach einem der vorangegangenen Ansprüche, dadurch gekennzeichnet, dass eine höhere Zeitauflösung dadurch erreicht wird, dass mehrere MTIAs (13a-d) parallel eingesetzt werden, welche mit zeitversetzten System-Clocks getaktet werden, wobei die Ereignisse (25a-d) mittels einer den MTIAs (13a-d) vorgeschalteten Ereignis-Verteilungseinheit (14) auf die verschiedenen MTIAs (13a-d) verteilt werden.

FIG.1

EP 0 568 771 A1

FIG.2

FIG. 3

Europäisches
Patentamt

**EUROPÄISCHER RECHERCHENBERICHT**

Nummer der Anmeldung

EP    93 10 1793
Seite 1

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| X | PATENT ABSTRACTS OF JAPAN vol. 12, no. 319 (P-751)30. August 1988 & JP-A-63 083 880 ( TOSHIBA ) 14. April 1988 * Zusammenfassung * --- | 1 | G01K3/14 G01K11/12 |
| X | DATABASE WPI Week 9045, 25. Oktober 1990 Derwent Publications Ltd., London, GB; AN 90-341159 ANONYMOUS: "Real - time histogram measurement hardware - has inter - arribal histogram memory containing history for number of times that number of inter - arrival time of VCI number fell in - range". INTERNATIONAL TECHNOLOGY DISCLOSURES, MARCH  1990 --- | 1 | |
| A | DATABASE WPI Week 8817, Derwent Publications Ltd., London, GB; AN 88-118599 & SU-A-1 341 651 (ZHAROV) 30. September 1987 * Zusammenfassung * --- | 1,3 | **RECHERCHIERTE SACHGEBIETE (Int. Cl.5 )** G01K G01R |
| A | PATENT ABSTRACTS OF JAPAN vol. 16, no. 377 (P-1401)12. August 1992 & JP-A-41 18 778 ( FUJITSU ) 20. April 1992 * Zusammenfassung * --- -/-- | 1 | |

Der vorliegende Recherchenbericht wurde für alle Patentansprüche erstellt

| Recherchenort | Abschlußdatum der Recherche | Prüfer |
|---|---|---|
| DEN HAAG | 18 AUGUST 1993 | RAMBOER P. |

Europäisches Patentamt

# EUROPÄISCHER RECHERCHENBERICHT

Nummer der Anmeldung

EP    93 10 1793
Seite 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| A | 1992 RESEARCH INSTRUMENTATION CATALOG; LECROY CORP., RESEARCH SYSTEM DIVISION Oktober 1991, US Seiten 135 - 145 '3512, 3521A, 3587, 3588, 4202, MM8206A  PROGRAMMABLE SPECTROSCOPY SYSTEM' * Seite 137 - Seite 140 * --- | 1,3 | |
| D,A | 1992 RESEARCH INSTRUMENTATION CATALOG; LECROY CORP., RESEARCH SYSTEM DIVISION Oktober 1991, US Seiten 51 - 53 '1879 PIPELINE MULTIHIT TIME-TO-DIGITAL CONVERTER' * das ganze Dokument * --- | 1 | |
| A | 1992 RESEARCH INSTRUMENTATION CATALOG; LECROY CORP., RESEARCH SYSTEM DIVISION Oktober 1991, US Seiten 45 - 49 '1877 MULTIHIT TIME-TO-DIGITAL CONVERTER' * das ganze Dokument * --- | 1,3 | |
| A | IEEE TRANSACTIONS ON NUCLEAR SCIENCE Bd. NS-34, Nr. 4, August 1987, NEW YORK US Seiten 958 - 960 L.O. LINDQUIST E.A. 'A CAMAC SYSTEM CONTROLLED BY AN IBM AT COMPUTER FOR TIME-RESOLVED SPECTROSCOPY' * Seite 958 * --- | 1 | |
| A | FR-A-2 552 552 (COMMISSARIAT A L'ENERGIE ATOMIQUE) 29. März 1985 * Seite 7, Zeile 12 - Seite 10, Zeile 3 * ----- | 1 | |

**RECHERCHIERTE SACHGEBIETE (Int. Cl.5 )**

Der vorliegende Recherchenbericht wurde für alle Patentansprüche erstellt

| Recherchenort | Abschlußdatum der Recherche | Prüfer |
|---|---|---|
| DEN HAAG | 18 AUGUST 1993 | RAMBOER P. |